Europäisches Patentamt

European Patent Office

Office européen des brevets

(19)

(11) **EP 0 687 066 B1**

(12) # EUROPEAN PATENT SPECIFICATION

(45) Date of publication and mention
of the grant of the patent:
**06.10.1999 Bulletin 1999/40**

(51) Int Cl.⁶: **H03K 17/082**

(21) Application number: **94830284.9**

(22) Date of filing: **10.06.1994**

(54) **Overvoltage protection device for an integrated circuit and corresponding method**

Überlastschutzanordnung für eine integrierte Schaltung und entsprechendes Verfahren

Dispositif de protection contre les surcharges pour un circuit intégré et procédé correspondant

(84) Designated Contracting States:
**DE FR GB IT**

(43) Date of publication of application:
**13.12.1995 Bulletin 1995/50**

(73) Proprietor: **CO.RI.M.ME.**
**CONSORZIO PER LA RICERCA SULLA**
**MICROELETTRONICA NEL MEZZOGIORNO**
**I-95121 Catania (IT)**

(72) Inventors:
• **Bontempo, Gregorio**
**I-98051 Barcellona (IT)**

• **Pulvirenti, Francesco**
**I-95024 Acireale (IT)**
• **Colletti, Paolo**
**I-98100 Messina (IT)**
• **Gariboldi, Roberto**
**I-20084 Lacchiarella (IT)**

(74) Representative: **Botti, Mario**
**Botti & Ferrari S.r.l.**
**Via Locatelli, 5**
**20124 Milano (IT)**

(56) References cited:
**EP-A- 0 624 951     US-A- 5 091 816**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

## Description

Field of the Invention

This invention relates to a non-dissipative overload protection device for protecting an integrated circuit having multiple independent channels against overloading.

Specifically, the invention concerns a non-dissipative device for the overload protection of an independent multi-channel integrated circuit, which device comprises an input terminal and an output terminal having an integrated switch connected therebetween which consists of a first or input portion, a two-input logic gate, a second or control portion, and a third or output portion, all in series with one another.

The invention further relates to a method for timing an integrated switch on and off under a short condition, the switch being connected in a multi-channel integrated circuit which includes a counter block and a storage element.

Background Art

As is known, in the field of industrial process controllers, ample use is made of control channels or lines which are powered at voltages exceeding 20 volts.

Most actuators, e.g. relays, solenoid valves, light indicators, heaters, etc., are driven from a control line relative to ground.

Switches of the integrated type, the so-called IPS's (Intelligent Power Switches), are specially useful to drive actuators of that kind. IPS's, in fact, can be implemented using BiCmos/Dmos technologies in such a manner that they can be properly operated at high voltages (on the order of 60 volts).

Furthermore, IPS's obtained by means of BiCmos/Dmos technologies exhibit negligible saturation power compared to that involved by the actuators.

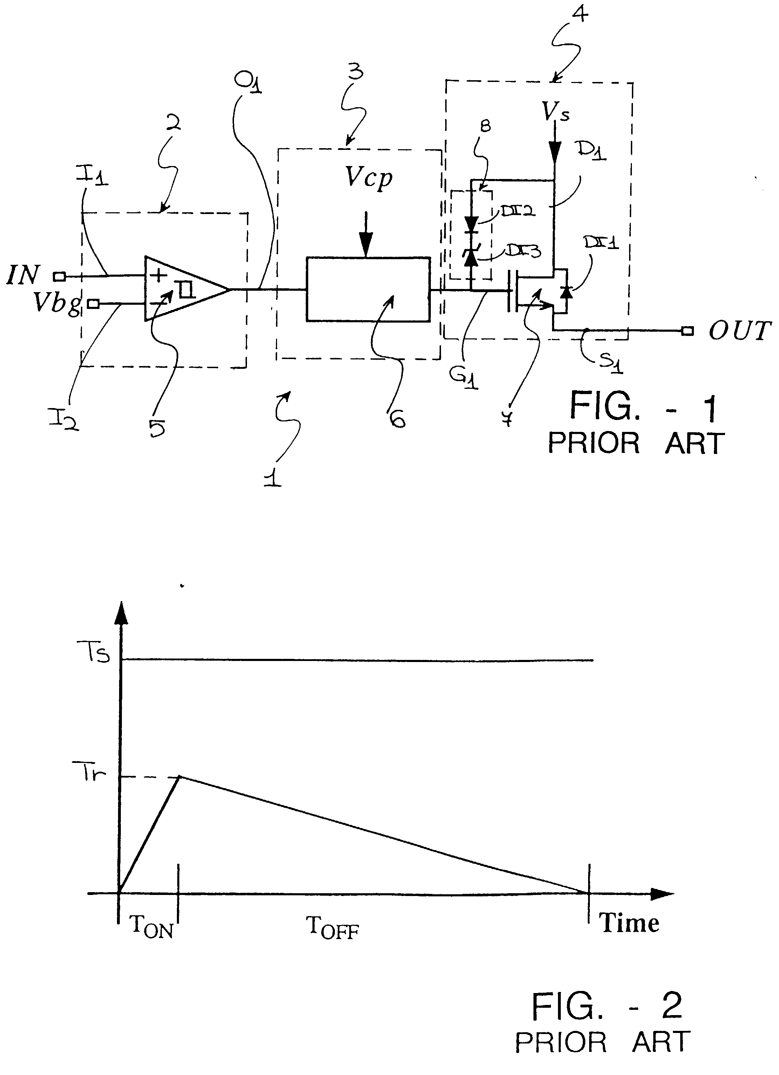

The topology usually employed to make integrated switches is one known as High Side Driver and shown diagramatically in Figure 1.

Generally shown at 1 in that figure is an IPS type of integrated switch implemented by BiCmos/Dmos technology.

That switch 1 has an input terminal IN and an output terminal OUT. Connected serially between these terminals are a first or input portion 2, a second or control portion 3, and a third or output portion 4.

The first or input portion 2 is comprised basically of a comparator 5 having a first input terminal I1 which is the terminal IN, and a second input terminal I2 connected to a voltage reference Vbg.

The second or control portion 3 is connected to the output of the input comparator 5 and comprised of a driver circuit 6 connected to a supply voltage pole Vcp.

The third or output portion 4 comprises a DMOS transistor 7, i.e. a field-effect transistor, or an n-channel MOS.

The DMOS transistor 7 has its drain D1 and gate G1 terminals connected to each other through a series of two diodes DI2 and DI3, with the latter being a zener diode.

In addition, the drain terminal D1 is connected to a supply voltage pole Vs, while the source terminal S1 is connected to the output terminal OUT.

This High Side Driver configuration operates as follows.

When the voltage value applied to the input IN is low compared to the voltage Vbg, the DMOS transistor 7 is off, i.e. non-conducting, and the output OUT has a high impedance; under this condition, the integrated switch 1 is said to be "open".

When the voltage value present at the input IN is high compared to the voltage Vbg, then the DMOS transistor 7 is on, i.e. in the conduction area, and establishing electric connection between the output OUT and the supply voltage pole Vs. The output OUT has a very low impedance equal to the resistance Rdson between the source terminal S1 and the drain terminal D1 of the DMOS transistor 7 in the conduction area; under this condition, the integrated switch is said to be "closed".

If the output OUT of the integrated switch 1 in the "closed" state is connected incidentally to a ground voltage reference GND, producing a short, the current being flowed through the DMOS transistor 7 becomes quite high, being only limited by the small impedance Rdson and the connections to the load of the switch 1.

This high current value leads to breakage of the assembling wires or failure of the switch. Therefore, the shorting current of the integrated switch 1 should be kept low.

One prior solution consists of keeping this current at a controlled low value. The DMOS 7 is held there shorted at a definite safe current value until the temperature of the integrated circuit rises to a threshold value Ts which triggers on a thermal protection for the switch, while turning off the DMOS transistor 7.

Actually, this prior solution is disadvantageous in that the integrated switch, with a continuing shorted condition, goes in and out of the thermal protection range, and is alternately heated and cooled about the threshold temperature Ts (which is usually on the order of 170°C), thereby its reliability is bound to undergo long term deterioration.

To overcome this problem, the prior art has proposed that non-dissipative protection devices be used.

Such devices dwell in the shorted condition with a controlled current for an appropriate time interval Ton during which the integrated switch will reach a temperature Tr, turn off the driver circuit 6 for a second predetermined time interval Toff, and if needed, repeat this operation until the switch comes out of the shorted condition. In this way, the steady state temperature Tr of the integrated switch is held at all times below a threshold temperature value Ts.

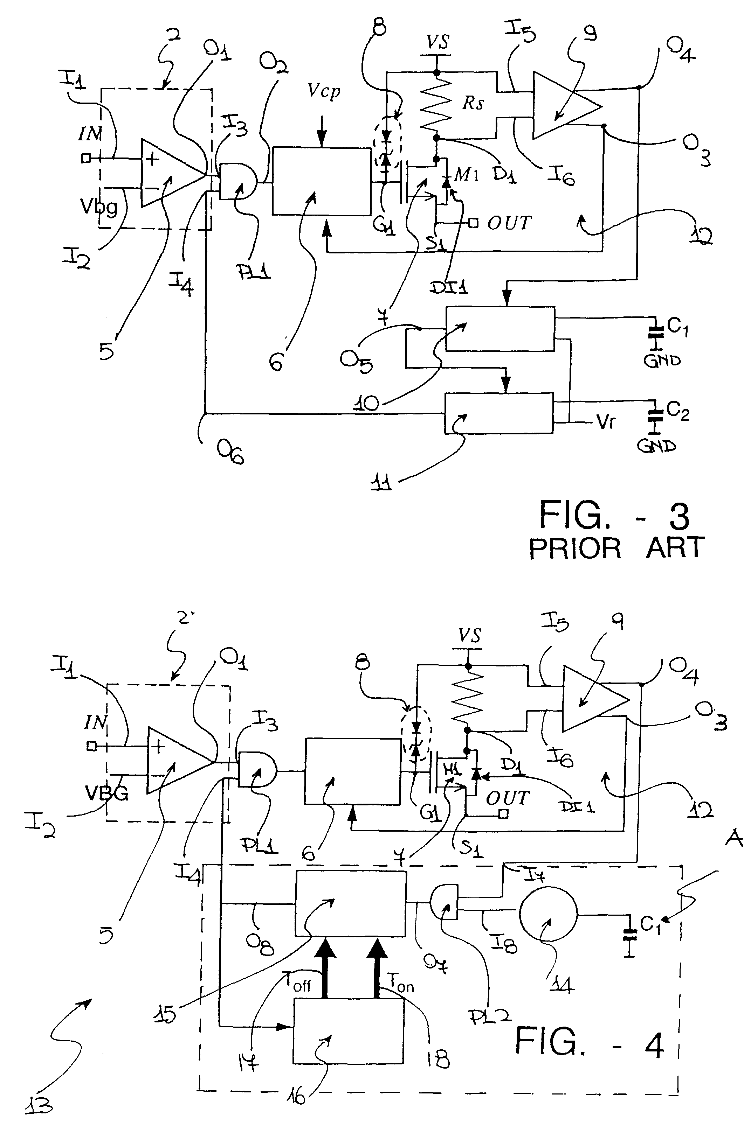

Figure 2 of the appended drawings shows graphically the temperature pattern plotted versus time.

It can be evinced from that graph that the protective device allows a steady state temperature Tr of the integrated switch to be attained which is far lower than the thermal protection cut-in temperature Ts.

The protection afforded by a device which operates in the manner just described is undoubtedly more reliable than that provided by the thermal protection alone.

The duration of the time interval Ton is vital to loads of a capacitive nature, filament lamps, etc.. In fact, such loads present a very low turn-on resistance and are seen by the protection device as shorted loads; accordingly, during the time interval Ton, the load capacitance is allowed to become charged.

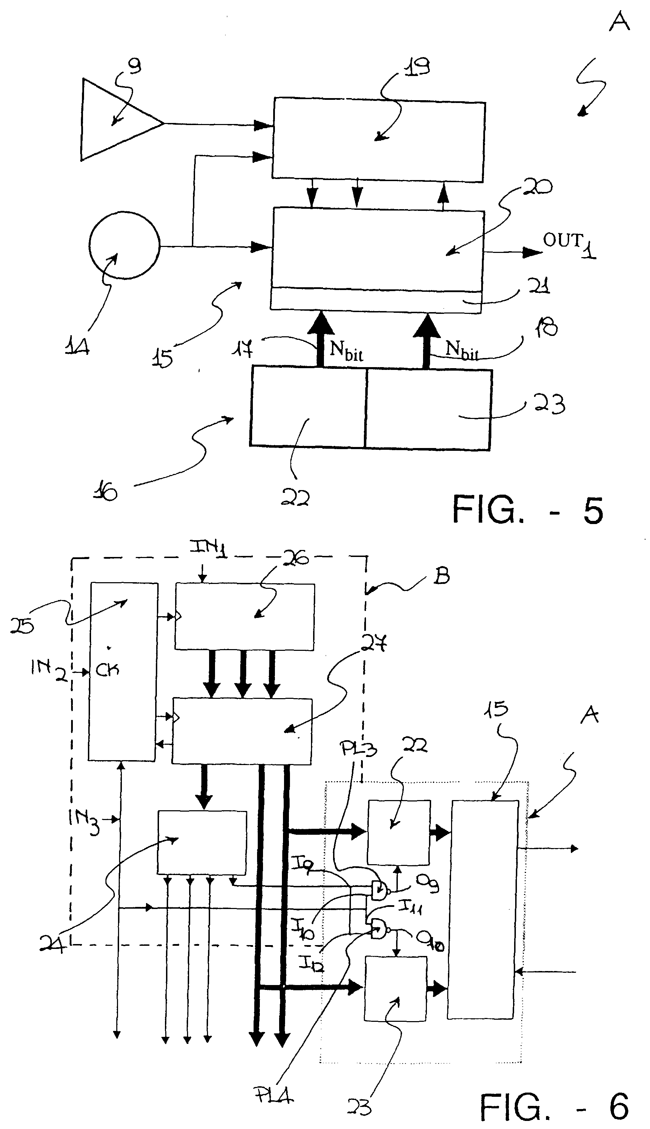

The circuit arrangement proposed by the prior art to effect this type of protection is shown in Figure 3, and may be regarded as a development of the device in Figure 1.

The output O1 of the comparator 5 is connected to the input of the driver circuit 6 by a logic gate PL1 of the AND type having two inputs I3, I4 and an output 02. Further, the drain terminal D1 of the DMOS transistor 7 is connected to a supply voltage reference Vs through a resistor Rs.

Connected across the resistor Rs are the input terminals of an operational amplificator 9 which has a first output terminal 03 feedback connected to the driver circuit 6 and a second output terminal 04 connected to a series of two delay blocks 10 and 11.

The delay blocks 10 and 11 are connected to the same voltage reference Vr and to a respective capacitor, C1 and C2.

The second delay block 11 is connected to the second input I4 of the logic gate PL1.

With the circuit architecture of Figure 3, the current flowing through the load is passed through the resistor Rs and is sensed at the input terminals of the operational amplifier 9 as a voltage difference $Vrs=Rs*Icc$.

Upon the load current exceeding the highest current for which the DMOS transistor 7 has been designed, the consequent increase in the voltage Vrs across Rs triggers on the control loop 12 formed by the negative feedback of the operational amplifier 9 to the driver circuit 6.

Thus, the driver circuit 6 keeps the current flowing through the DMOS transistor 7 within its designed limiting value.

At the same time, the output 04 from the operational amplifier 9 will be acting on the first delay block 10, whose time lag Ton is set by the capacitor C1 charge and the reference voltage Vr.

After the time interval Ton, the voltage VC1 on the capacitor CI will be higher than the reference value Vr, and the output 05 of the first delay block 10 will go to a logic high, causing the capacitor C2 to discharge and pulling to zero the output 06 of the second delay block 11.

The logic low state of the output 06 of the second delay block 11 also pulls down the output 02 of the logic gate PL1, which will turn off the driver circuit 6.

At this point, there will be no current flowing through the load, and hence through Rs, and the control loop 12 is disabled; the output 04 of the operational amplifier 9 is at a logic low, causing the capacitor C1 to be discharged and pulling to zero the output 05 of the first delay block 10.

The disappearance of the signal from the output 05 of the first delay block 10 allows the capacitor C2 to be charged to a voltage VC2. The time interval Toff is set by the charge value of C2 and the threshold reference voltage Vr.

After the time interval Toff, the voltage VC2 on the capacitor C2 will be exceeding the reference value Vr, the value of the output 06 of the second delay block 11 will be restored to a logic high, and control of the DMOS transistor 7 handed back to the comparator 5 of the first input circuit portion 2.

Where the abnormal operating condition is continued, the whole procedure is repeated along with a request to turn on the integrated switch 1.

This prior circuit reveals some shortcomings when used for protecting integrated circuits having multiple control channels, which may be shorted, or for driving different capacitive loads. In fact, when this solution is to be adapted for multiple control channel IC's, one can proceed in two different ways, neither of which is devoid of drawbacks.

In a first mode of applying the circuit, it could be considered of using but two capacitors C1 and C2 for all the channels in the integrated circuit.

In this case, an obvious disadvantage comes from the channel times Ton and Toff being dependent on the first channel to become shorted.

In the second application mode, a pair of capacitors C1 and C2 can be used for each of the channels present in the integrated circuit.

An inherent disadvantage of the last-mentioned option is either an inordinate increase in occupied area due to the presence of so many capacitors, or the need to have two terminating contacts added for each channel if one chooses to use external capacitors of the integrated circuit.

The technical problem that underlies this invention is to provide an overload protection device and a timing method for an integrated circuit having multiple independent channels, which is effective to overcome the drawbacks with which the prior art has been beset.

Summary of the Invention

The solutive idea on which this invention stands is one of using a single capacitor to generate a common time base shared by all the channels of the integrated circuit, and of achieving independence of the time intervals Ton and Toff of each channel by employing memories of the EPROM or EEPROM type.

The technical problem is solved by a device as indicated above and defined in the characterizing part of Claim 1.

The problem is also solved by a method for obtaining discrete on-times Ton and off-times Toff for each channel of the integrated circuit from values stored within a storage element, as defined in the characterizing part of Claim 14.

The features and advantages of the device and the method according to this invention will become apparent from the following detailed description of an embodiment thereof, to be taken by way of example and not of limitation in conjunction with the accompanying drawings.

Brief Description of the Drawings

In the drawings:

- Figure 1 shows in diagrammatic form an integrated switch embodying the state of the art;

- Figure 2 is a plotting of temperature vs. time for the switch of Figure 1;

- Figure 3 illustrates an overload protection device embodying the state of the art;

- Figure 4 illustrates an overload protection device embodying this invention;

- Figure 5 shows in greater detail a portion of the circuit in Figure 4;

- Figure 6 illustrates a data storage device within the portion of Figure 5; and

- Figure 7 shows current and voltage patterns for the circuit of Figure 4.

Detailed Description

With reference to the drawing figures, generally shown at 13 is a non-dissipative, overload protection device which embodies this invention.

The device 13 is intended to protect an integrated circuit, not illustrated because conventional.

The protection device 13 has an input terminal IN and an output terminal OUT with an integrated switch 1 of a known type connected therebetween.

The integrated switch 1 comprises a series of a first or input circuit portion 2 including a comparator 5, a second circuit portion 3 with control function which includes a driver circuit 6, and a third or output circuit portion 4 including a DMOS transistor and a series of diodes 8.

Connected between the comparator 5 and the driver circuit 6 is a first logic gate PL1 of the AND type having two inputs, I3 and I4, and an output O2.

The DMOS transistor 7 has its drain terminal D1 connected to a supply voltage reference Vs through a resistor Rs having two inputs, I5 and I6, of an operational amplifier 9 connected across it.

The operational amplifier 9 has a first output 03 feedback-connected to the driver circuit 6 into a feedback loop 12.

In accordance with the invention, connected between a second output 04 of the operational amplifier 9 and the second input I4 of the first logic AND gate PL1, is a circuit A to generate the on-times Ton and off-times Toff of the integrated switch 1.

Specifically, the second output 04 of the operational amplifier 9 is connected to a first input I7 of a second logic AND gate PL2 having two inputs I7, I8 and an output 07.

The second input I8 of the logic AND gate PL2 is connected to an oscillator 14 of the free running type which is connected serially toward ground to a capacitor C1.

The output 07 of the logic AND gate PL2 is connected to the input of a counter block 15 connected, in turn, to the input I4 of the first logic AND gate PL1 and to a storage block 16. The memory 16 supplies the counter block 15 with the values of the on- and off-times Ton and Toff, respectively, for the device 13 over buses 17 and 18.

Such a device 13 can only be implemented using BCD (Bipolar CMOS DMOS) technologies, which allow memory cells, signal components and power components to be integrated to the same integrated circuit.

The protection provided by this device is based on the generation of a common time base for all the channels of the integrated circuit to which the device is applied.

For this purpose, the device 13 uses the free running oscillator 14, whose oscillation frequency Fosc is inversely proportional to the capacitance value of the capacitor C1. In particular, an oscillation frequency is obtained as follows:

$$Fosc = K/C1 \qquad (1)$$

The resultant time base is used in the inventive method as a clock signal for the counter block 15 which is to count the times Ton and Toff.

The number of clock pulses counted by the counter block 15 is controlled by the storage block 16.

In particular, the values of Ton and Toff are obtained by suitable selection of the count start value, which would be different for each individual channel to be controlled.

In the method of this invention, such start values for the individual channels are stored in the storage block 16.

The operation of the device according to the invention will now be discussed.

With the output OUT of the device 13 connected to a ground voltage reference GND, the signal at the output 04 of the operational amplifier 9, as generated by the control loop 12 between the amplifier and the driver circuit 6, goes from a logic low (logic "0") to a logic high (logic "1").

Through the logic AND gate PL2, this signal triggers on the counting, in accordance with the time base set by the oscillator 14, of the on-time Ton and off-time Toff by the counter block 15.

At the start of this count, there is loaded from the storage block 16 the initial state of the counter block 15 at the channel of interest, thereby loading into the counter block 15 a required pattern of bits to generate the appropriate on-time interval Ton.

The counting proceeds in accordance with this pattern of bits which, during the time interval Ton, will be brought to a logic value of "1". During this starting stage of the count, the current through the DMOS transistor 7 is set at a reliable definite value.

If, during this count starting stage, the short condition of the output OUT is terminated, the block 15 count is at once clamped, and the whole device 13 restored to its normal operation state.

At the end of the time interval Ton, the driver circuit 6 is controlled to go off regardless of the control signal at the input IN, and from the storage block 16, the count starting value for the off-time Toff is then loaded.

At this point, a second counting stage starts for the time interval Toff, during which the driver circuit 6 would be held in the off state.

At the end of the second counting stage, control of the driver circuit 6 is returned to the input circuit portion 2, whereupon the device 13 will be ready to signal the presence of another short by re-initiating the sequence of operations just described.

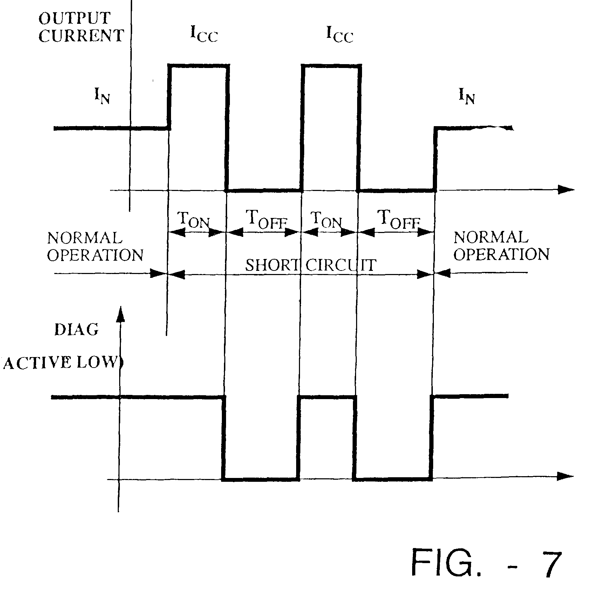

Figure 5 shows in greater detail the aggregate of the counter 15 and storage 16 blocks, as shared in common by each channel in the integrated circuit.

The operational amplifier 9 is shown therein connected to a first logic block 19, in turn connected to the oscillator 14 and the counter block 15.

The counter block 15 comprises a counter 20 and a multiplexer sub-block 21, and is connected to the storage block 16 which is comprised of a first memory 22 arranged to contain the start value of the count related to the on-time interval Ton, and a second memory 23 containing the start value of the count related to the off-time interval Toff.

In the preferred embodiment of the device 13 according to the invention, the memories 22 and 23 are of the EEPROM type.

If N is used to denote the number of the counting elements (flip-flops) in the counter block 15, then the longest possible on- and off-times, Ton and Toff, are tied to the oscillation frequency of the oscillator 14 by the following relation:

$$T(on,off) = 2^N/Fosc \qquad (2)$$

The memories 22 and 23 are connected to the multiplexer sub-block 21 by buses 17 and 18, respectively.

The circuit of Figure 5 operates as follows.

The logic block 19 completes all the steps required to operate the block A of the device 13 in Figure 4. For instance, this block 19 would arrange for the storing of the counter 20 starting state, control the loading of data from the EEPROM memories 22 and 23 into the counter block 15, etc..

The multiplexer sub-block 21 functions to send the values related to the on- and off-times Ton, Toff present on the buses 17 and 18 to the counter 20.

Advantageously, according to the invention, the output OUT1 from the counter block 15 can be used to generate a diagnostic signal externally of the integrated circuit.

At this point, the problem of how to store the data into the storage block 16 is to be addressed.

When the memories 22 and 23 are, as in the preferred embodiment, of the EEPROM type, the initialization circuit B shown in Figure 6 can be used for this storing step.

The initialization circuit B has three input terminals IN1, IN2 and IN3 which are to receive signals from the circuit outside world.

The input terminal IN1 receives the data to be stored in the serial mode as clocked in by a clock signal CK present on the input terminal IN2.

The third input terminal IN3 receives a signal enabling the block B to program the storage block 16, and should be kept active throughout this time period.

Since the input terminals IN1 and IN2 are only used during the programming step of the EEPROM memories 22 and 23, the invention advantageously provides for existing terminations in the integrated circuit intended for other signals to be shared therewith.

The first input terminal IN1 is connected to the storage block 16 through a cascade of a shift register 26, a buffer storage register 27 and a channel decoder 24.

The second input terminal IN2 is connected to the counter block 25, and the third input terminal IN3 is connected to the counter block 25 and to the logic gate pair, PL3 and PL4.

The shift register 26 and the buffer register 27 are input, through the counter block 25, the clock signal CK generated by the oscillator circuit 14.

In particular, the circuit B is connected to the EEPROM memories 22 and 23 through a parallel of two logic AND gates PL3 and PL4 having two inputs I9, I10 and I11, I12, respectively, and one output O9 and O10, respectively.

The outputs O9 and O10 of these logic gates PL3, PL4 are respectively connected to the EEPROM memories 22 and 23, while the inputs I9 and I11 are connected together and to the program enable input IN3.

The counter block 25 is connected to the shift register 26 and the buffer register 27, in series with each other, and the buffer register 27 is connected to the channel decoder 24 and the memories 22 and 23.

The counter block 25, channel decoder 24 and buffer register 27 are connected to all the channels of the integrated circuit.

The operation of the device of Figure 6 during the EEPROM 22 and 23 programming step will be discussed next.

The signal at the input IN3, which is held on throughout the programming step, is first enabled.

The serial data to the input IN1 from the outside world are placed into the shift register 26, which is clocked through the counter block by the clock signal CK.

The data pattern is as follows:

1. value of Ton (represented by means of N1 bits),

2. value of Toff (represented by means of N1 bits), and

3. channel number (represented by means of N2 bits).

The counter block 25 is then to count (2*N1+N2) clock pulses. Thereafter, the buffer register 27 is enabled into which the data to be decoded is placed, allowing the shift register 26 to acquire fresh data in the course of the EEPROM decoding and programming step.

The channel decoder 24 identifies the channel selected for programming, where writing into the memory cells is enabled, and transfers the values of data related to Ton and Toff.

The procedure described above is carried on until all the EEPROM memories are programmed.

Advantageously, according to the invention, the overload protection device 13 can be streamlined by keeping the on-time Ton fixed and only programming the off-time Toff, or vice versa.

In addition, where the time programming is only needed once, as the time intervals cannot be changed, memories of the EPROM type may be used.

Also, if the times are fixed, the storage block 16 can be omitted altogether, and the whole programming block B with it.

Shown in Figure 7 are patterns of the current flowed through the DMOS transistor 7 and of the voltage on the system diagnostic output OUT1, illustrating the circuit operation under normal and shorted conditions.

Thus, the device 13 of this invention uses a single capacitor C1 which generates a common time base, shared by all the channels of the integrated circuit; accordingly, such channels may be provided in any number.

In addition, each channel is quite independent of the others, in the sense that on the occurrence of problems with any one channel, the protection procedure would only be initiated for that channel and the operation of the other channels remain unaffected.

The on-time Ton and off-time Toff intervals may be any selected ones to suit the load requirements of each channel.

Finally, the digital arrangement for computing the time intervals Ton and Toff affords superior immunity from noise, since the values of these time intervals are stored in digital cells rather than as voltages values across a capacitor, as was the case with the prior art.

The latter additional advantage is quite important on account of these integrated circuits being used in industrial environments bound to be very noisy. In fact, the appearance of spurious signals, voltage and/or current spikes, or electromagnetic interference, would be more likely to alter the charge stored on a capacitor than change the value of a written bit.

## Claims

1. A non-dissipative overload protection device (13) for protecting an integrated circuit having multiple independent channels against overloading, comprising an input terminal (IN) and an output terminal (OUT) having an integrated switch (1) connected therebetween which consists of a first or input portion (2), a logic gate (PL1) with two inputs (I3,I4), a second or control portion (3), and a third or output portion (4), all in series with one another, a circuit (A) for generating on- and off-times (Ton,Toff) of the integrated switch (1), said circuit (A) being connected between an output (O4) of the third portion (4) and a first input terminal (I4) of said logic gate (PL1), characterized in that said circuit (A) comprises an oscillator (14) connected, through a second logic AND gate (PL2), to a counter block (15) in turn connected to said first input (I4) of the first logic AND gate (PL1), said counter block (15) being connected to a memory element (16) storing on- and off-time values (Ton,Toff) of the integrated switch (1).

2. An overload protection device according to Claim 1, characterized in that said oscillator (14) is connected to a ground voltage reference (GND) through a capacitor (C1) and its oscillation frequency (Fosc) is inversely proportional to the value of said capacitor (C1).

3. An overload protection device according to Claim 1, characterized in that said second logic AND gate (PL2) has an input terminal (I7) connected to said output (O4) of the third portion (4).

4. An overload protection device according to Claim 1, characterized in that said counter block (15) is connected, over buses (17,18), to said memory element (16).

5. An overload protection device according to Claim 1, wherein said third portion (4) comprises an operational amplifier (9), characterized in that said generating circuit (A) includes an additional logic block (19) connected to the operational amplifier (9), the oscillator (14), and the counter block (15).

6. An overload protection device according to Claim 5, characterized in that said counter block (15) comprises a counter (20) and a multiplexer (21).

7. An overload protection device according to Claim 4, characterized in that said memory element (16) is an EEPROM.

8. An overload protection device according to Claim 7, characterized in that said EEPROM memory element (16) comprises a first storage portion (22) containing data related to the on-time values (Ton) of the integrated switch (1) and a second storage portion (23) containing data related to the off-time values (Toff) of the integrated switch (1).

9. An overload protection device according to Claim 4, characterized in that it comprises an initialization circuit (B) connected to the memory element (16).

10. An overload protection device according to Claim 9, characterized in that said initialization circuit (B) has three input terminals (IN1,IN2,IN3), a first (IN1) of said input terminals receiving data related to the on- and off-time values (Ton,Toff) of the integrated circuit (1) and being connected to the memory element (16) through a series of a shift register (26), a buffer storage register (27) and a channel decoder block (24), and the second and third (IN2,IN3) of said input terminals respectively receiving the clock signal (CK) generated by the oscillator (14) of the generating circuit (A) and an initialization function enable signal and being connected to the memory element (16) through a series of a counter block (25) and the buffer storage register (27).

11. An overload protection device according to Claim 10, characterized in that said shift register (26) and buffer storage register (27) are connected, through the counter block (25), to the clock signal (CK) generated by the oscillator (14) of the generating circuit (A).

12. An overload protection device according to Claim 11, characterized in that said channel decoder block (24) is connected to the buffer storage register (27) and to a parallel combination of two logic AND gates (PL3,PL4) having two inputs (I9,I10 and I11,I12) and an output (O9,O10).

13. An overload protection device according to Claim 12, characterized in that said logic AND gates (PL3,PL4) have first (I9,I12) of said input terminals connected together and to the channel decoder block (24), second (I10,I11) of said input terminals connected together and to the third input terminal (IN3) of the initialization circuit (B), and the output terminals (09,010) connected to a first and a second storage portion (22,23) of the memory element (16), respectively.

14. A method for obtaining on- and off-times (Ton,Toff) of an integrated switch (1) being connected to a multi-channel integrated circuit, characterized by generating a common time base (CK) in an oscillator circuit (14), shared by all the channels of the integrated circuit, and by controlling with said common time base a counter block (15) to generate the on- and off-times (Ton,Toff) according to on- and off time/values loaded from a memory element (16) where they are stored, when overload has been detected.

15. A method for obtaining times according to Claim 14, characterized in that different starting values of the on- and off-times (Ton,Toff) are stored in the memory element (16) for each channel of the integrated circuit having the integrated switch (1) connected therein.

16. A method for obtaining times according to Claim 15, characterized in that the starting values of the on-times (Ton) are stored in a first storage portion (22) and the starting values of the off-times (Toff) are stored in a second storage portion (23).

17. A method for obtaining times according to Claim 15, characterized in that the said oscillator circuit (14) is connected to a voltage reference (GND) via a capacitor (C1), said oscillator circuit (14) having an oscillation frequency (Fosc) which is inversely proportional to the capacitance of said capacitor (C1).

**Patentansprüche**

1. Verlustlose Überlastschutzvorrichtung (13) zum Schützen einer integrierten Schaltung, die mehrere unabhängige Kanäle aufweist, gegen Überlast, umfassend einen Eingangseinschluß (IN) und einen Ausgangsanschluß (OUT), zwischen denen ein integrierter Schalter (1) liegt, bestehend aus einem ersten oder Eingangsteil (2), einem logischen Gatter (PL1) mit zwei Eingängen (I3, I4), einem zweiten oder Steuerteil (3), und einem dritten oder Ausgangsteil (4), die sämtlich in Reihe zueinander geschaltet sind, eine Schaltung (A) zum Generieren von Ein- und Aus-Zeiten (Ton, Toff) des integrierten Schalters (1), wobei die Schaltung (A) zwischen einem Ausgang (O4) des dritten Teils (4) und einem ersten Eingangsanschluß (I4) des logischen Gatters (PL1) liegt,
**dadurch gekennzeichnet**,
daß die Schaltung (A) einen Oszillator (14) aufweist, der über ein zweites logisches UND-Gatter (PL2) an einen Zählblock (15) angeschlossen ist, der seinerseits an den ersten Eingang (I4) des ersten logischen UND-Gatters (PL1) angeschlossen ist, wobei der Zählblock (15) an ein Speicherelement (16) angeschlossen ist, welches Ein- und Ausschaltzeitwerte (Con, Coff) des integrierten Schalters (1) speichert.

2. Überlastschutzvorrichtung nach Anspruch 1,
**dadurch gekennzeichnet**,
daß der Oszillator (14) über eine Kapazität (C1) an Referenz-Massespannung (GND) angeschlossen ist und seine Schwingungsfrequenz (Fosc) umgekehrt proportional zu dem Wert der Kapazität (C1) ist.

3. Überlastschutzvorrichtung nach Anspruch 1,
**dadurch gekennzeichnet**,
daß das zweite logische UND-Gatter (PL2) mit einem Eingangsanschluß (I7) an den Ausgang (O4) des dritten Teils (4) angeschlossen ist.

4. Überlastschutzvorrichtung nach Anspruch 1,
**dadurch gekennzeichnet**,
daß der Zählblock (15) über Busse (17, 18) an das Speicherelement (16) angeschlossen ist.

5. Überlastschutzvorrichtung nach Anspruch 1,
**dadurch gekennzeichnet**,
daß das dritte Teil (4) einen Operationsverstärker (9) aufweist, dadurch gekennzeichnet, daß die Generatorschaltung (8) einen zusätzlichen logischen Block (19) aufweist, der an den Operationsverstärker (9), den Oszillator (14) und den Zählblock (15) angeschlossen ist.

6. Überlastschutzvorrichtung nach Anspruch 5,
**dadurch gekennzeichnet**,
daß der Zählblock (15) einen Zähler (20) und einen Multiplexer (21) aufweist.

7. Überlastschutzvorrichtung nach Anspruch 4,
**dadurch gekennzeichnet**,
daß das Speicherelement (16) ein EEPROM ist.

8. Überlastschutzvorrichtung nach Anspruch 7,
**dadurch gekennzeichnet**,
daß das EEPROM-Speicherelement (16) einen ersten Speicherabschnitt (22), der Daten über die Ein-Zeitwerte (Ton) des integrierten Schalters (1) enthält, und einen zweiten Speicherabschnitt (23), der Daten über die Aus-Zeitwerte (Toff) des integrierten Schalters (1) enthält, aufweist.

9. Überlastschutzvorrichtung nach Anspruch 4,
**dadurch gekennzeichnet**,
daß sie eine an das Speicherelement (16) angeschlossene Initialisierungsschaltung (B) aufweist.

10. Überlastschutzvorrichtung nach Anspruch 9,
**dadurch gekennzeichnet**,
daß die Initialisierschaltung (B) drei Eingangsanschlüsse (IN1, IN2, IN3) aufweist, von denen ein erster Anschluß (IN1) Daten über die Ein- und Aus-Zeitwerte (Ton, Toff) der integrierten Schaltung (1) empfängt und an das Speicherelement (17) über einer Reihe aus einem Schieberegister (26), einem Pufferspeicherregister (27) und einem Kanaldecoderblock (24) angeschlossen ist, und von denen der zweite und der dritte Eingangsanschluß (IN2, IN3) das von dem Oszillator (14) der Generatorschalter (8) erzeugte Taktsignal (CK) bzw. ein Initialisierungsfunktions-Freigabesignal empfangen und an das Speicherlement (16) über eine Reihe aus einem Zählblock (25) und dem Pufferspeicherregister (27) angeschlossen sind.

11. Überlastschutzvorrichtung nach Anspruch 10,
**dadurch gekennzeichnet**,
daß das Schieberegister (26) und das Pufferspeicherregister (27) über den Zählblock (25) an das von dem Oszillator (14) der Generatorschaltung (A) erzeugte Taktsignal angeschlossen sind.

12. Überlastschutzvorrichtung nach Anspruch 11,
**dadurch gekennzeichnet**,
daß der Kanaldecoderblock (24) an das Pufferspeicherregister (27) und an eine Parallelschaltung aus zwei logischen UND-Gattern (PL3, PL4) mit jeweils zwei Eingängen (I9, I10 und I11, I12) und einem Ausgang (O9, O10) angeschlossen ist.

13. Überlastschutzvorrichtung nach Anspruch 12,
**dadurch gekennzeichnet**,
daß die logischen UND-Gatter (PL3, PL4) mit dem ersten (I9, I12) der Eingangsanschlüsse zusammengeschaltet und an den Kanaldecoderblock geschaltet sind, mit dem zweiten (I10, I11) der Eingangsanschlüsse zusammengeschaltet und an den dritten Eingangsanschluß (IN3) der Initialisierungsschaltung (B) angeschlossen sind, während die Ausgangsanschlüsse (O9, O10) an einen ersten bzw. einen zweiten Speicherteil (22, 23) des Speicherelements angeschlossen sind.

14. Verfahren zum Erhalten der Ein- und Ausschaltzeiten (Ton, Toff) eines integrierten Schalters (1), der an eine integrierte Mehrkanal-Schaltung angeschlossen ist,
**gekennzeichnet durch**
das Generieren einer gemeinsamen Zeitbasis (CK) in einer Oszillatorschaltung (14), die gemeinsam von sämtlichen Kanälen der integrierten Schaltung benutzt wird, und durch Steuern eines Zählblocks (15) mit der gemeinsamen Zeitbasis, um die Ein- und Ausschaltzeiten (Ton, Toff) nach Maßgabe von Ein- und Aus-Zeitwerten zu generieren, wenn eine Überlast nachgewiesen wurde, wobei die Ein- und Aus-Zeitwerte aus einem Speicherelement (16) geladen werden, wo sie gespeichert sind.

15. Verfahren nach Anspruch 14,
**dadurch gekennzeichnet**,
daß verschiedene Anfangswerte für die Ein- und Ausschaltzeiten (Ton, Toff) in dem Speicherelement (16) für jeden Kanal der integrierten Schaltung gespeichert sind, in welchem der integrierte Schalter (1) angeschlossen ist.

16. Verfahren nach Anspruch 15,
**dadurch gekennzeichnet**,
daß die Anfangswerte der Ein-Zeiten (Ton) in einem ersten Speicherteil (22) und die Anfangswerte der Aus-Zeiten (Toff) in einem zweiten Speicherteil (23) abgespeichert sind.

17. Verfahren nach Anspruch 15,
**dadurch gekennzeichnet**,
daß die Oszillatorschaltung (14) über einen Kondensator (C1) an eine Referenzspannung (GND) angeschlossen ist und eine Schwingungsfrequenz (Fosc) aufweist, die umgekehrt proportional zu dem Wert der Kapazität (C1) ist.

**Revendications**

1. Dispositif non-dissipatif de protection contre les surcharges (13), destiné à protéger un circuit intégré ayant de multiples canaux indépendants contre les surcharges, comportant une borne d'entrée (IN) et une borne de sortie (OUT) ayant un commutateur intégré (1), connecté entre celles-ci, constitué d'une première partie d'entrée (2), d'une porte logique (PLI) avec deux entrées (13, 14), une deuxième partie de commande (3), et une troisième partie de sortie (4), toutes montées en série les unes avec les autres, un circuit (A) pour générer des périodes de temps de mise en fonction et d'extinction (Ton, Toff) du commutateur intégré (1), ledit circuit (A) étant connecté entre une sortie (O4) de la troisième partie (4) et une première borne d'entrée (14) de ladite porte logique (PLI), caractérisé en ce que ledit circuit (A) est constitué d'un oscillateur (14) relié, par l'intermédiaire d'une deuxième porte logique ET (PL2), à un bloc de comptage (15) relié à son tour à ladite première entrée (14) de la première porte logique ET (PL1), ledit bloc de comptage (15) étant relié à un élément mémoire (16) mémorisant les valeurs de temps de mise en fonction et de temps d'extinction (Ton, Toff) du commutateur intégré (1).

2. Dispositif de protection contre les surcharges suivant la revendication 1, caractérisé en ce que ledit oscillateur (14) est relié à une référence de tension à la masse (GND) par l'intermédiaire d'un condensateur (C1) et sa fréquence d'oscillation (Fosc) est inversement proportionnelle à la valeur dudit condensateur (C1).

3. Dispositif de protection contre les surcharges suivant la revendication 1, caractérisé en ce que ladite deuxième porte logique ET (PL2) possède une borne d'entrée (17) reliée à ladite sortie (O4) de ladite troisième partie (4).

4. Dispositif de protection contre les surcharges suivant la revendication 1, caractérisé en ce que ledit bloc de comptage (15) est relié, par des bus (17, 18), audit élément mémoire (16).

5. Dispositif de protection contre les surcharges suivant la revendication 1, dans lequel ladite troisième partie (4) comporte un amplificateur opérationnel (9), caractérisé en ce que ledit circuit de génération (A) comporte un bloc logique supplémentaire (19) relié à l'amplificateur opérationnel (9), l'oscillateur (14) et le bloc de comptage (15).

6. Dispositif de protection contre les surcharges suivant la revendication 5, caractérisé en ce que ledit bloc de comptage (15) comporte un compteur (20) et un multiplexeur (21).

7. Dispositif de protection contre les surcharges suivant la revendication 4, caractérisé en ce que ledit élément mémoire (16) est une EEPROM.

8. Dispositif de protection contre les surcharges suivant la revendication 7, caractérisé en ce que ledit élément mémoire EEPROM (16) comporte une première partie de mémorisation (22) contenant les données relatives aux valeurs de temps de mise en fonction (Ton) du commutateur intégré (1) et une deuxième partie de mémorisation (23) contenant les données relatives aux valeurs de temps d'extinction (Toff) du commutateur intégré (1).

9.  Dispositif de protection contre les surcharges suivant la revendication 4, caractérisé en ce qu'il comporte un circuit d'initialisation (B) relié à l'élément mémoire (16).

10. Dispositif de protection contre les surcharges suivant la revendication 9, caractérisé en ce que ledit circuit d'initialisation (B) possède trois bornes d'entrée (IN1, IN2, IN3), une première (IN1) desdites bornes d'entrée recevant les données relatives aux valeurs de temps de mise en fonction et d'extinction (Ton, Toff) du circuit intégré (1) étant reliée à l'élément mémoire (16) en série et par l'intermédiaire d'un registre à décalage (26), d'un registre de mémorisation tampon (27) et d'un bloc décodeur de canal (24), et la deuxième et la troisième (IN2, IN3) desdites bornes d'entrée respectivement recevant le signal d'horloge (CK) généré par l'oscillateur (14) du circuit de génération (A) et un signal de validation de fonction d'initialisation et étant relié à l'élément mémoire (16) en série et par l'intermédiaire d'un bloc de comptage (25) et d'un registre de mémorisation tampon (27).

11. Dispositif de protection contre les surcharges suivant la revendication 10, caractérisé en ce que lesdits registre à décalage (26) et registre de mémorisation tampon (27) sont connectés, par l'intermédiaire du bloc de comptage (25), au signal d'horloge (CK) généré par l'oscillateur (14) du circuit de génération (A).

12. Dispositif de protection contre les surcharges suivant la revendication II, caractérisé en ce que ledit bloc décodeur de canal (24) est connecté au registre de mémorisation tampon (27) et à une combinaison parallèle de deux portes logiques ET (PL3, PL4) ayant deux entrées (I9, I10 et I11, I12) et une sortie (O9, O10).

13. Dispositif de protection contre les surcharges suivant revendication 12, caractérisé en ce que lesdites portes logiques ET (PL3, PL4) ont les premières (I9, I12) desdites bornes d'entrée connectées ensemble et au bloc décodeur de canal (24), les deuxièmes (I10, I11) desdites bornes d'entrée connectées ensemble et à la troisième borne d'entrée (IN3) du circuit d'initialisation (B), et les bornes de sortie (O9, O10) connectées à une première et à une deuxième partie de mémorisation (22, 23) de l'élément mémoire (16), respectivement.

14. Procédé pour obtenir les temps de mise en fonction et d'extinction (Ton, Toff) d'un commutateur intégré (1) connecté à un circuit intégré multicanaux, caractérisé en ce qu'il comporte les étapes de génération d'une base de temps commune (CK) dans un circuit oscillateur (14) partagée par tous les canaux du circuit intégré, et de commande, avec ladite base de temps commune, d'un bloc de comptage (15) afin de générer les temps de mise en fonction et d'extinction (Ton, Toff) suivant les temps / valeurs de mise en fonction et d'extinction chargés dans un élément mémoire (16) où ils sont mémorisés, lorsqu'une surcharge a été détectée.

15. Procédé pour obtenir les temps suivant la revendication 14, caractérisé en ce que différentes valeurs de début des temps de mise en fonction et d'extinction (Ton, Toff) sont mémorisées dans l'élément mémoire (16) pour chaque canal du circuit intégré ayant le commutateur intégré (1) connecté à celui-ci.

16. Procédé pour obtenir les temps suivant la revendication 15, caractérisé en ce que les valeurs de début des temps de mise en fonction (Ton) sont mémorisées dans une première partie de mémorisation (22) et les valeurs de début des temps d'extinction (Toff) sont mémorisées dans une deuxième partie de mémorisation (23).

17. Procédé pour obtenir les temps suivant la revendication 15, caractérisé en ce que ledit circuit oscillateur (14) est connecté à une référence de tension (GND) par l'intermédiaire d'un condensateur (C1), ledit circuit oscillateur (14) ayant une fréquence d'oscillation (Fosc) inversement proportionnelle à la capacité dudit condensateur (C1).

FIG. - 1
PRIOR ART

FIG. - 2
PRIOR ART

FIG. - 3
PRIOR ART

FIG. - 4

FIG. - 5

FIG. - 6

FIG. - 7